Europäisches Patentamt

European Patent Office

Office européen des brevets

(11) Veröffentlichungsnummer: **0 263 342**
**A2**

## (12) EUROPÄISCHE PATENTANMELDUNG

(21) Anmeldenummer: **87113741.0**

(22) Anmeldetag: **19.09.87**

(51) Int. Cl.⁴: **H05K 5/00**

(30) Priorität: **01.10.86 CH 3923/86**

(43) Veröffentlichungstag der Anmeldung:
**13.04.88 Patentblatt 88/15**

(84) Benannte Vertragsstaaten:
**AT BE DE FR LU NL SE**

(71) Anmelder: **ZELLWEGER USTER AG**
**Wilstrasse 11**
**CH-8610 Uster(CH)**

(72) Erfinder: **Nussbaumer, Roland**
**Unterbühlenstrasse 32**
**CH-8610 Uster(CH)**

(54) **Stromrichter und Verwendung des Stromrichters als Frequenzumformer für Rundsteuersender.**

(57) Der Stromrichter enthält eine Anzahl von elektronischen Elementen (3, 5, 7, 8, 9) und Kühlelementen (2), welche alle auf einer gemeinsamen, als tragender Bauteil ausgebildeten Trägerplatte (1) montiert ist. Die Trägerplatte (1) weist die erforderlichen elektrischen Anschlüsse (10, 11, 14) auf und ist mit einer im entsprechenden Gerät montierten Grundplatte über Stecker (10, 11, 14) verbindbar.

Durch diesen modularen Aufbau kann der Stromrichter einfach an wechselnde Leistungstypen angepasst werden, ohne dass konstruktive Aenderungen erforderlich wären. Der Stromrichter ist rationell zu fertigen und zu prüfen und ist ausserdem äusserst bedienungs-und servicefreundlich.

Eine bevorzugte Anwendung ist der Einsatz des Stromrichters als Frequenzumformer für Rundsteuersender.

FIG. 2

EP 0 263 342 A2

## Stromrichter und Verwendung des Stromrichters als Frequenzumformer für Rundsteuersender

Die Erfindung betrifft einen Stromrichter mit Halbleiterelementen, Elementen für die Zündung, Beschaltungselementen, Kühlelementen und Bauteilen mit tragenden und/oder isolierenden Funktionen.

Derartige Stromrichter werden heute vielfach verwendet und wirken bekanntlich als elektrische Ventile, die nur in eine Richtung stromdurchlässig sind. Man unterscheidet dabei zwischen sogenannten echten und unechten Ventilen, wobei als echte Ventile heute Thyristoren eingesetzt werden. Abgesehen davon, dass ein Stromrichter dieser Art Halterungen für verschiedenartige Elemente aufweisen muss, rationell fertigbar und an verschiedene Leistungsanforderungen möglichst ohne konstruktive Aenderungen der tragenden Bauteile anpassbar sein muss, ergeben sich auch Probleme elektrischer Natur. Diese bestehen insbesondere darin, dass hohe Spannungen und Ströme vorhanden sind, was zu nicht unerheblichen Isolationsproblemen führt, dass, in Abhängigkeit von den auftretenden Frequenzen, nur sehr kurze elektrische Verbindungen zulässig sind, und dass auf relativ kleinem Raum hohe Verlustleistungen entstehen.

Diese Probleme konnten bisher nicht befriedigend gelöst werden und es gibt insbesondere keine Stromrichter, welche ohne tiefgreifende Aenderungen an den tragenden Bauteilen für verschiedene Leistungen ausgelegt werden können.

Durch die Erfindung soll nun ein Stromrichter angegeben werden, welcher sich durch einfachen und übersichtlichen Aufbau und damit durch Servicefreundlichkeit auszeichnet, welcher rationell gefertigt und geprüft werden kann und welcher die Verwendung des gleichen tragenden Bauteils für verschiedene Leistungstypen ermöglicht.

Diese Aufgabe wird erfindungsgemäss dadurch gelöst, dass die genannten Elemente auf einem gemeinsamen, als tragender Bauteil ausgebildeten Träger angeordnet sind, welcher die erforderlichen elektrischen Anschlüsse aufweist und mit einer im entsprechenden Gerät montierten Grundplatte lösbar verbindbar ist.

Der erfindungsgemässe Stromrichter ist also modular aufgebaut und kann durch entsprechende Bestückung des Trägers einfach an verschiedene Leistungstypen und/oder Bauformen angepasst werden. Er ist ausserdem rationell zu fertigen, indem die einzelnen Stromrichter-Module als Untergruppen fertig fabrizier-und prüfbar sind, und er ist ausserdem äusserst bedienungs-und servicefreundlich.

Die Erfindung betrifft weiter eine Verwendung des genannten Stromrichters als Frequenzumformer für Rundsteuersender, wobei mehrere, vorzugsweise sechs, Stromrichter in einem gemeinsamen Gehäuse mit einer Ventilationseinrichtung angeordnet sind.

Diese Verwendung ist dadurch gekennzeichnet, dass man die einzelnen Stromrichter als Montageblock in einer gemeinsamen Ebene in Reihen und Kolonnen anordnet und diesen Montageblock als Ventilationskanal ausbildet.

Nachfolgend wird die Erfindung anhand eines in den Zeichnungen dargestellten Ausführungsbeispiels näher erläutert; es zeigen:

Fig. 1 eine Frontansicht eines erfindungsgemässen Stromrichtermoduls im Massstab 1:2,

Fig. 2 eine Ansicht in Richtung des Pfeiles II von Fig. 1,

Fig. 3 eine Aussicht in Richtung des Pfeiles III von Fig. 2, und

Fig. 4 eine schematische Darstellung der Anordnung von Stromrichtermodulen in einem Rundsteuersender.

Der in den Figuren dargestellte Stromrichter ist ein solcher, bei dem als elektrisches Ventil ein Thyristor verwendet wird. Da die elektronische Schaltung und deren Aufbau nicht Gegenstand der vorliegenden Patentanmeldung bildet, wird sie hier nicht näher erläutert, sondern es wird in diesem Zusammenhang auf die Publikationen "Einführung in die Stromrichtertechnik" von Otto Kolb, Fachschriftenverlag Aargauer Tagblatt AG, Aarau/Schweiz 1976 und "DECABIT, das neue elektronische AEG-Zellweger-Rundsteuersystem" von Walter Dehn in Technische Mitteilungen AEG-TELEFUNKEN 16 (1971) 6, verwiesen.

Derartige Stromrichter enthalten bei Verwendung als Frequenzumformer für Rundsteuersender neben dem Thyristor und den diesem zugeordneten Bauelementen (Zündungs-und Beschaltungselemente) eine Freilaufdiode, eine sogenannte Snubber-Schaltung mit einem Widerstand und einem Kondensator, sowie je ein Kühlelement für den Thyristor, die Freilaufdiode und den Widerstand.

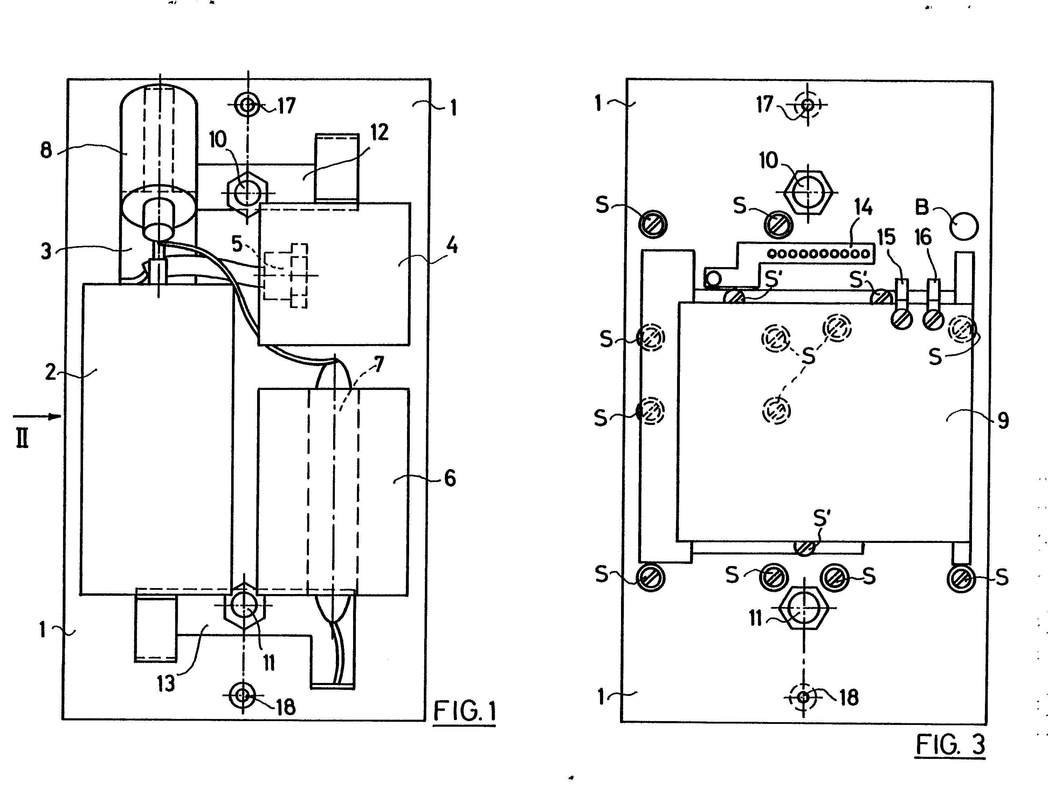

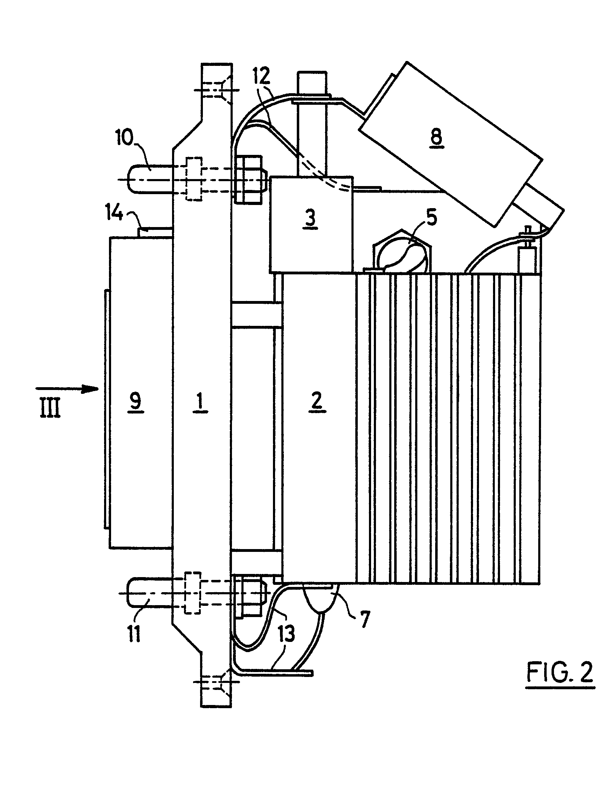

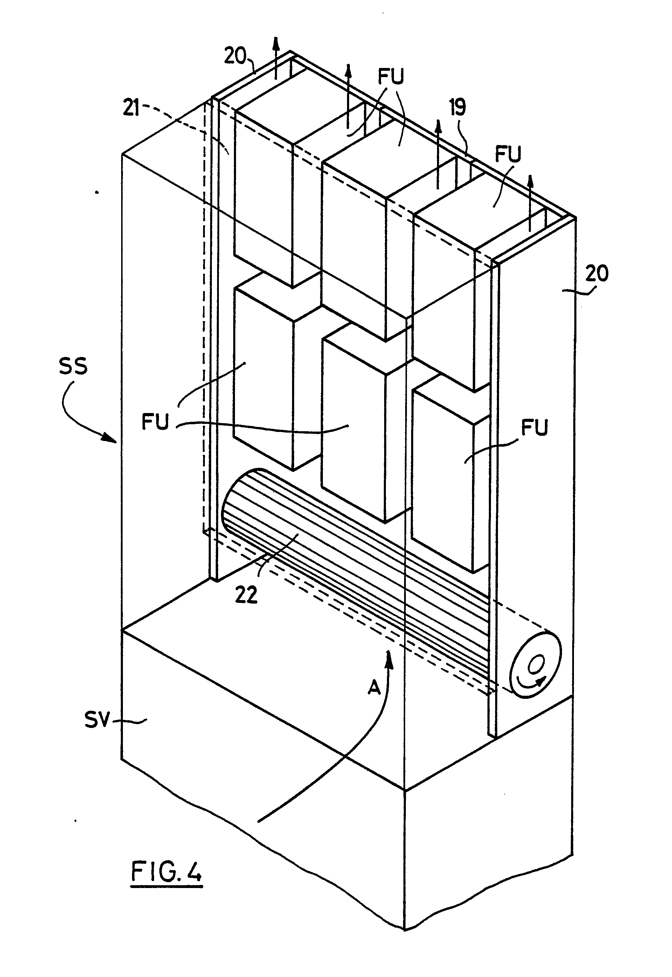

Gemäss den Figuren 1 bis 3 weist der Stromrichter ein einziges tragendes Bauteil in Gestalt einer Trägerplatte 1 auf, welche aus einem geeigneten, vorzugsweise aus einem geschäumten, Kunststoff (z.B. PPO-TSG) besteht und auf welcher sämtliche Elemente befestigt sind. Auf der in Fig. 1 dem Betrachter zugewandten Vorderseite der Trägerplatte 1 sind insgesamt drei Kühlelemente montiert: Ein erstes Kühlelement 2 für den Abschaltthyristor (GTO) 3, ein zweites Kühlelement 4 für die Freilaufdiode 5, und ein drittes Kühlelement 6 für den Widerstand 7. Die Kühlelemente 2, 4 und 6, welche aus Aluminium bestehen und rippenartig ausgebildet sind, sind jeweils an die Trägerplatte 1 angeschraubt (Schrauben S in Fig. 3) und tragen ihrerseits das zugeordnete elektronische Bauelement, das heisst, den Thyristor 3 bzw. die Freilaufdiode 5 bzw. den Widerstand 7. Ausserdem ist auf der Vorderseite der Trägerplatte 1 noch ein Kondensator 8 befestigt. Die gesamte Zündungs-und Beschaltungselektronik, der sogenannte Gate-Driver 9, der ebenfalls modulartig ausgebildet ist, ist an die Rückseite der Trägerplatte 1 angeschraubt (Schrauben S' in Fig. 3).

Die Stromversorgung der auf der Vorderseite der Trägerplatte 1 montierten Bauteile erfolgt über steckerartige Kontakte 10 und 11, welche in der Trägerplatte 1 gehalten und mit ihrem aus der Rückseite der Trägerplatte 1 ragenden zylindrischen Teil zum Eingriff in entsprechende Kontakte einer im Gehäuse des Rundsteuersenders angeordneten Grundplatte (nicht dargestellt) vorgesehen sind. Die Kontakte 10 und 11 sind über entsprechende Schienen 12 bzw. 13 mit den genannten Bauteilen elektrisch verbunden. Der Kontakt zum Gate-Driver 9 erfolgt über eine Steckersiene 14 a der Rückseite der Trägerplatte 1, deren Gegenstück ebenfalls auf der schon genannten Grundplatte vorgesehen ist. Von dieser Steckerschiene 14 führen Litzen einerseits zum Gate-Driver 9 und anderseits zu einer Temperatur-Ueberwachung. Die Kathode und das Gate des Thyristors 3 sind an Kontakte 15 bzw. 16 des Gate-Drivers 9 angeschlossen. Nach dem Einstecken der Trägerplatte 1 in die Grundplatte mittels der Kontakte 10 und 11 wird die Trägerplatte 1 auf der Grundplatte mittels in Bohrungen 17 und 18 geführter, unverlierbarer Schrauben fixiert.

Derartige Frequenzumformer für Rundsteuersendungen werden in der Regel entsprechend den jeweiligen Anforderungen in verschiedenen Leistungstypen hergestellt. Dabei ist die beschriebene Trägerplatte 1, und daher auch die entsprechende Grundplatte im Gehäuse des Rundsteuersenders, stets gleich und weist jeweils die Kontakte 10 und 11, die Bohrungen für die Schrauben S, S' der einzelnen Bauteile und die Bohrungen 17 und 18 für die Befestigung an der Grundplatte an der gleichen Stelle auf. In Fig. 3 erkennt man eine Bohrung B für eine Schraube S, die beim dargestellten Leistungstyp frei ist und erst bei einem anderen Typ mit einer anderen Anordnung der Kühlelemente benötigt wird. Eine Aenderung des Leistungstyps bedeutet also nur eine Bestückung der Trägerplatte 1 mit anderen Bauteilen und erfordert keinerlei konstruktive Aenderungen an der Trägerplatte 1 oder an der Grundplatte.

In Fig. 4 ist schematisch dargestellt, wie die Frequenzumformer in der Praxis eingesetzt werden. Darstellungsgemäss werden sechs mit FU bezeichnete Frequenzumformer in einen geeigneten Schaltschrank SS eingebaut, welcher in seinem unteren Teil eine mit SV bezeichnete Stromversorgungseinheit enthält. Die Frequenzumformer FU sind als Montageblock in einer gemeinsamen Ebene in zwei Reihen zu je drei beziehungsweise in drei Kolonnen zu je zwei Exemplaren angeordnet und die Grundplatten der Frequenzumformer FU bilden eine Rückwand 19. Ausserdem sind zwei Seitenwände 20 und eine Abdeckplatte 21 vorgesehen. Unterhalb des Montageblocks ist eine antreibbare Ventilationswalze 22 angeordnet, bei deren Rotation Aussenluft in Richtung des Pfeiles A angesaugt wird, die verschiedenen Ventilationskanäle zwischen den einzelnen Kolonnen der Frequenzumformer FU und zwischen diesen und den Seitenwänden 20 durchströmt und dann nach oben in Richtung der eingezeichneten Pfeile aus dem Schaltschrank SS entweicht. Der Schaltschrank SS weist zur Ermöglichung dieser Ventilation an seiner Vordertür entsprechende Lufteintritts-und an seiner oberen Abdeckplatte entsprechende Luftaustrittsöffnungen auf. An der Innenseite der Vordertüre des Schaltschranks SS ist im Bereich des durch die Frequenzumformer FU gebildeten Montageblocks ein Steuerkasten angeordnet, welcher die Abdeckplatte 21 zusätzlich nach vorne hin abdeckt. Beim Oeffnen der Vordertüre wird mit dieser auch der Steuerkasten von den Frequenzumformern FU weggeschwenkt, so dass diese nach Entfernen der Abdeckplatte 21 frei zugänglich sind.

**Ansprüche**

1. Stromrichter mit Halbleiterelementen, Elementen für die Zündung, Beschaltungselementen, Kühlelementen und mit Bauteilen mit tragenden und/oder isolierenden Funktionen, dadurch gekennzeichnet, dass die genannten Elemente (2 bis 9) auf einem gemeinsamen, als tragender Bauteil ausgebildeten Träger (1) angeordnet sind, welcher die erforderlichen elektrischen Anschlüsse (10, 11, 14) aufweist und mit einer im entsprechenden Gerät montierten Grundplatte lösbar verbindbar ist.

2. Stromrichter nach Anspruch 1, dadurch gekennzeichnet, dass der Träger (1) durch eine Platte gebildet ist, deren elektrische Anschlüsse (10, 11, 14) und Befestigungspunkte für die einzelnen Elemente (2 bis 9) für verschiedene Leistungstypen jeweils an der gleichen Stelle vorgesehen sind.

3. Stromrichter nach Anspruch 2, dadurch gekennzeichnet, dass die einzelnen Elemente (2 bis 9) an die Platte (1) angeschraubt oder von auf die Platte angeschraubten Elementen gehalten sind.

4. Stromrichter nach einem der Ansprüche 1 bis 3, dadurch gekennzeichnet, dass der Träger (1) mit der Grundplatte mittels elektrischer Steckkontakte (10, 11) und Schrauben mechanisch verbindbar ist.

5. Stromrichter nach Anspruch 4, dadurch gekennzeichnet, dass der Träger (1) an seiner von der Grundplatte abgewandten Seite mit einem Thyristor (3), einer Diode (5), einem Widerstand (7) und mit je einem diesen elektronischen Bauteilen zugeordneten Kühlelement (2, 4, 6) bestückt ist, wobei jedes Kühlelement direkt auf dem Träger befestigt ist und die genannten elektronischen Bauteile von ihrem jeweiligen Kühlelement gehalten sind.

6. Stromrichter nach Anspruch 5, dadurch gekennzeichnet, dass die Elemente für die Zündung und die Beschaltungselemente auf der der Grundplatte zugewandten Seite des Trägers (1) montiert sind.

7. Stromrichter nach Anspruch 6, dadurch gekennzeichnet, dass die Bauteile (2 bis 8) an der der Grundplatte abgewandten Seite des Trägers (1) über Kontaktschienen (12, 13) an die elektrischen Steckkontakte (10 bzw. 11) angeschlossen sind.

8. Stromrichter nach Anspruch 7, dadurch gekennzeichnet, dass die Elemente an der der Grundplatte zugewandten Seite des Trägers (1) an eine Kontaktleiste (14) auf dem Träger angeschlossen sind, welche zum Eingriff in eine entsprechende Kontaktleiste der Grundplatte vorgesehen ist.

9. Verwendung des Stromrichters gemäss Anspruch 1 als Frequenzumformer für Rundsteuersender, wobei mehrere, vorzugsweise sechs, Stromrichter in einem gemeinsamen Gehäuse mit einer Ventilationseinrichtung angeordnet sind, dadurch gekennzeichnet, dass man die einzelnen Stromrichter (FU) als Montageblock in einer gemeinsamen Ebene in Reihen und Kolonnen anordnet und diesen Montageblock als Ventilationskanal ausbildet.

10. Verwendung nach Anspruch 9, dadurch gekennzeichnet, dass man den Montageblock, dessen Rückwand (19) durch die Grundplatten der Stromrichter (FU) gebildet ist, mit zwei Seitenwänden (20) und einer Abdeckplatte (21) abdeckt und die Luft der Ventilationseinrichtung (21) durch den so gebildeten Kanal leitet.

11. Verwendung nach Anspruch 10, dadurch gekennzeichnet, dass man den Montageblock mit den Seitenwänden (20) und der Abdeckplatte (21) in einem Schaltschrank (SS) anordnet, welcher mit Ein-und Austrittsöffnungen für die Ventilationsluft versehen ist.

12. Verwendung nach Anspruch 11, dadurch gekennzeichnet, dass die Ventilationseinrichtung durch eine unterhalb des Montageblocks angeordnete antreibbare Ventilationswalze (22) gebildet ist.

FIG. 3

FIG.1

FIG. 2

FIG.4